# EUROPEAN PATENT SPECIFICATION

(11) **EP 4 498 530 B1**
(45) Date of publication and mention of the grant of the patent: **26.08.2026**
(21) Application number: 23922419.9
(22) Date of filing: 22.11.2023
(51) Int. Cl.: H05K 1/02, H05K 1/14, H04M 1/02, H01R 12/62

(54) **ELECTRONIC DEVICE**
ELEKTRONISCHE VORRICHTUNG
DISPOSITIF ÉLECTRONIQUE

(30) Priority: 17.02.2023 CN 202320302937 U
(43) Date of publication of application: 29.01.2025
(73) Proprietor: Honor Device Co., Ltd., Shenzhen, Guangdong 518040 (CN)
(72) Inventor: DONG, Xiaoyong, Shenzhen, Guangdong 518040 (CN)
(74) Representative: Goddar, Heinz J.
(86) International application number: PCT/CN2023/133280
(87) International publication number: WO 2024/169303

(56) References cited:
- CN-A- 102 623 796
- CN-A- 112 153 845
- CN-A- 115 189 189
- CN-U- 206 806 609
- CN-U- 216 251 134
- CN-U- 217 508 805
- CN-U- 219 696 727
- JP-A- 2009 199 816
- US-A1- 2014 177 180
- US-A1- 2018 287 302
- US-A1- 2019 261 515
- US-A1- 2019 341 688
- US-A1- 2022 216 629

## Description

### TECHNICAL FIELD

This application relates to the field of hardware technologies, and in particular, to an electronic device.

### BACKGROUND

To implement fast charging, most electronic devices currently use high-current charging solutions. Therefore, to avoid overheating and damage of a universal serial bus (universal serial bus, USB) port in a high-current charging scenario, a housing at the USB interface is usually suspended. In this way, a risk of port burning due to a short circuit is low even if water enters the USB interface.

It can be understood that a USB socket is disposed inside the electronic device, to fasten the USB interface in the electronic device. There are two types of USB sockets. The first type of USB socket is connected to only a flexible printed circuit (flexible printed circuit, FPC), and the first type of USB socket may be fastened on the electronic device by using screws on two sides of the USB socket, so as to serve as a ground component.
However, when the USB interface is disposed at an edge of the electronic device, the screws cannot be mounted on the two sides of the USB socket, and therefore, it is difficult to apply the first type of USB socket. In this case, the second type of USB socket may be applied. The second type of USB socket may be directly welded to a high density interconnector (high density interconnector, HDI) printed circuit, and the USB socket may fix a location of the FPC, to implement electrical signal access. Because the second type of USB socket cannot be electrically connected to the housing, the FPC cannot be grounded by using the USB socket, and grounding of the FPC becomes a problem to be resolved urgently.
US 2014/177180 A1 discloses electrical components in an electronic device that are mounted on substrates such as printed circuits. In an embodiment shown in Figures 18 and 19, the electronic device comprises a flexible printed circuit, a board-to-board connector, a rigid printed circuit, and shielding structures; the rigid printed circuit and the flexible printed circuit are disposed opposite to each other and spaced apart; and the shielding structures and the connector are disposed between the rigid printed circuit and the flexible printed circuit, and the flexible printed circuit is electrically connected to the rigid printed circuit by using the shielding structures and the connector to enable the flexible printed circuit to ground, and the electronic device comprises stiffening structures attached to the flexible printed circuit.
Printed circuits contain signal paths formed from metal traces.
The signal lines in the signal paths of the printed circuits are coupled together using electrical connection structures such as printed circuit board-to-board connectors, contacts joined by anisotropic conductive film, or contacts joined using solder. Electrical connection structures may be surrounded by conductive resilient ring-shaped structures such as conductive foam structures or spring structures. The conductive foam structures may be provided with a metal layer with which the conductive foam structures are soldered to a ring of metal on a printed circuit. Strain relief structures may be formed from an elastomeric ring that surrounds the electrical connection structures or an over molded plastic structure. Coating layers and conductive plastic may be used in providing strain relief structures with electromagnetic interference shielding capabilities.
US 2019/261515 A1 discloses an electronic device. The electronic device includes a conductive support member, a first circuit board connected to the conductive support member by a first capacitor, a second circuit board connected to the conductive support member by a second capacitor, a first conductive connection member electrically connecting the first circuit board and the second circuit board, and a first ground structure, at least a portion of the first ground structure being interposed between the first conductive connection member and the conductive support member. The ground structure includes a non-conductive layer physically contacting the conductive support member, and a conductive layer electrically connected to the first conductive connection member to form a capacitive coupling with the conductive support member.
JP 2009 199816 A discloses an electronic apparatus capable of enhancing a shield effect by reducing connection resistance when grounding a connector component to be grounded to a frame of a housing of the apparatus or the like. The electronic apparatus includes a circuit board having a wiring pattern with electronic components mounted thereon, and a connector for transmitting/receiving signals to/from an external apparatus. The electronic apparatus also includes a shielding flexible board for shielding electromagnetic noise generated from the circuit board and the electronic components by covering the circuit board and the electronic components. The flexible board is structured to cover the circuit board and the electronic components from both surfaces by being folded back. It is preferable that conductive elastic bodies and electrically connecting the flexible board, a metallic shell of the connector and a metallic case of the electronic apparatus to one another are added.
CN 216 251 134 U discloses a terminal device antenna and a terminal device, the terminal device antenna comprises a first antenna support, a first flexible circuit board and a metal shell, the first flexible circuit board is connected with the metal shell, and the first antenna support is connected with the first flexible circuit board through a metal elastic sheet. Therefore, a grounding line which sequentially comprises the first antenna support, the metal elastic sheet, the first flexible circuit board and the metal shell is formed. According to the technical scheme, the first antenna support is connected with the metal shell through the first flexible circuit board, and then grounding is achieved. The flexible circuit board is thinner than a printed circuit board.
CN 102 623 796 A discloses a China mobile multimedia broadcasting (CMMB) antenna, which comprises an insulating base plate, a first antenna part and a second antenna part, wherein the insulating base plate includes a front side and a rear side, the first antenna part and the second antenna part are arranged on the front side and the rear side of the insulating base plate respectively, and the first antenna part is electrically connected with the second antenna part. According to the CMMB antenna and the mobile phone, the CMMB antenna is designed into a two side cabling type and is arranged on the surface of the insulating base plate, thereby the space occupied by the CMMB antenna is reduced. A mobile phone which contains the CMMB antenna is provided, the CMMB can be divided into two sections and arranged inside the mobile phone, thereby the defect that large and continuous space is needed when the antenna is wholly moulded is overcome, and a function of reasonably utilizing small space inside the mobile phone is achieved.
CN 217 508 805 U discloses electronic equipment. The electronic equipment comprises a middle frame, a mainboard and a microphone assembly, the middle frame comprises a middle plate and a frame extending from the edge of the middle plate, the middle plate and the frame define an accommodating space, and the frame is provided with a first pickup hole communicated with the accommodating space; the main board is accommodated in the accommodating space and is arranged on the middle board; the microphone assembly is accommodated in the accommodating space and is connected with the middle frame; the microphone assembly comprises a circuit board arranged on the middle plate, a microphone arranged on the circuit board, and a sound guide support arranged on the side, away from the microphone, of the circuit board. The sound guide support is provided with a sound guide channel which is communicated with the first pickup hole and the microphone. The projection of the microphone projected on the middle plate and the projection of the mainboard projected on the middle plate are staggered.
CN 206 806 609 U discloses an electronic device that shielding cover, a board-to-board connector, a motherboard, a flexible circuit board, and a magnetic metal reinforcing plate. The shielding cover has a through hole for the board-to-board connector to pass through. The board-to-board connector is fixedly connected to the motherboard and passes through the through hole to connect to the flexible circuit board. The magnetic metal reinforcing plate is located on the flexible circuit board, and the magnetic metal reinforcing plate and the board-to-board connector are respectively located on two opposite sides of the flexible circuit board. The magnetic metal reinforcing plate is magnetically attracted to the shielding cover and presses against the board-to-board connector.

### SUMMARY

This application provides an electronic device, to resolve a problem that it is difficult for an FPC to ground nearby in a case of an insufficient ground space in the conventional technology.

To resolve the foregoing technical problem, the invention provides, according to a first aspect, an electronic device of claim 1. The electronic device includes a flexible printed circuit, a preset connector, a mainboard, a mainboard ground member, and a conductive structural member. The mainboard and the flexible printed circuit are disposed opposite to each other and spaced apart in a first direction, and the mainboard is connected to the mainboard ground member, to ground by using the mainboard ground member. The conductive structural member and the preset connector are disposed between the mainboard and the flexible printed circuit, and the flexible printed circuit is electrically connected to the mainboard by using the conductive structural member and the preset connector, to enable the flexible printed circuit to ground by using the mainboard ground member.

That is, because the mainboard ground member is electrically connected to a ground wire, a conducting wire path used for grounding is shortened because two ground locations, that is, the conductive structural member and the preset connector, are disposed on a ground path, so that the flexible printed circuit is grounded nearby, and parasitic inductance generated by the flexible printed circuit is effectively reduced, thereby facilitating improvement of ground reliability of the flexible printed circuit.

Moreover, according to the first aspect, the electronic device includes a reinforcement plate, an external interface, and an interface socket configured to mount the external interface; and the flexible printed circuit is clamped between the interface socket and the reinforcement plate in the first direction.

That is, the flexible printed circuit is clamped by the interface socket of the external interface and the reinforcement plate, so that a location of the flexible printed circuit is kept stable, and the flexible printed circuit is grounded by using the conductive structural member.

In a possible implementation of the first aspect, a projection of the conductive structural member on the flexible printed circuit is at least partially overlapped with a projection of the reinforcement plate on the flexible printed circuit.

That is, a location that is of the conductive structural member and that supports the flexible printed circuit is at least partially overlapped with the reinforcement plate, thereby effectively ensuring grounding of the flexible printed circuit and ensuring ground reliability.

In a possible implementation of the first aspect, the conductive structural member is a first structural member; or the conductive structural member includes a second structural member and a third structural member that are stacked in the first direction, and the third structural member is located on one side that is of the second structural member and that faces away from the flexible printed circuit.

That is, the conductive structural member may be one first structural member or two structural members stacked in the first direction, that is, includes the second structural member and the third structural member, and the third structural member is located on the side that is of the second structural member and that faces away from the flexible printed circuit, to provide the second structural member with a support force in the first direction.

In a possible implementation of the first aspect, the first structural member includes a rigid material; and the second structural member includes a rigid material, and the third structural member includes a flexible material or a rigid material.

That is, a material of the first structural member may be a rigid material with elasticity, for example, a conductive elastic piece. A material of the second structural member may be a rigid material with elasticity, for example, a conductive elastic piece. The third structural member includes a flexible material or a rigid material, for example, conductive foam or a conductive elastic piece, to provide the second structural member with support in the first direction.

In a possible implementation of the first aspect, the flexible material is conductive foam, and the rigid material is a conductive elastic piece.

That is, the conductive foam or the conductive elastic piece is used as the conductive structural member, to facilitate mounting of the interface socket.

In a possible implementation of the first aspect, the flexible printed circuit includes, in a second direction, a first segment and a second segment that are connected to each other, and the second direction is perpendicular to the first direction; the third structural member includes, in the second direction, a first part and a second part that are connected to each other, and the third structural member is overlapped with the first segment of the flexible printed circuit by using the first part; and the second part of the third structural member is configured to provide the second segment of the flexible printed circuit with support in the first direction.

That is, the third structural member includes, in the second direction, the first part and the second part that are connected to each other, and in the first direction, supports, by using the first part, the first segment of the flexible printed circuit that is supported by the second structural member, and supports the second segment of the flexible printed circuit by using the second part, so that a bending angle of the flexible printed circuit is enlarged, thereby prolonging a service life of the flexible printed circuit.

In a possible implementation of the first aspect, the interface socket is located between the mainboard and the flexible printed circuit in the first direction, and the interface socket is located on a first side of the conductive structural member in the second direction; and a distance between the third structural member and the interface socket is less than a distance between the second structural member and the interface socket in the second direction.

That is, the interface socket is located between the mainboard and the flexible printed circuit, and the interface socket is located on the first side of the conductive structural member in the second direction, for example, the first side facing away from the second direction. Then, the distance between the third structural member and the interface socket is less than the distance between the second structural member and the interface socket in the second direction, so that the interface socket is prevented from scratching the second structural member in a process of mounting the interface socket, thereby ensuring an assembly yield of the electronic device.

In a possible implementation of the first aspect, parts of the third structural member have a same thickness, and the thickness is a size of the third structural member in the first direction.

That is, the third structural member has a uniform thickness, so that the third structural member is easily obtained.

In a possible implementation of the first aspect, the external interface includes a USB interface or a SIM card interface.

That is, the external interface may be a USB interface, for example, a USB Type-C interface, or may be an external interface such as a SIM card interface or a headset jack.

### BRIEF DESCRIPTION OF DRAWINGS

To describe technical solutions in this application more clearly, the following briefly describes accompanying drawings used for describing implementations.
FIG. 1 is a schematic diagram of a mobile phone 100 in which a USB socket is disposed;
FIG. 2 is a schematic diagram of a structure of an electronic device according to some embodiments of this application;
FIG. 3 is a rear view of an electronic device according to some embodiments of this application;
FIG. 4 is an S1-directional view of the electronic device shown in FIG. 3 in some embodiments;
FIG. 5 is an S1-directional view of the electronic device shown in FIG. 3 in some other embodiments;
FIG. 6 is an A-A cross-sectional diagram of the electronic device shown in FIG. 3 in some other embodiments;
FIG. 7 is a partially enlarged view of a region IV in the A-A cross-sectional diagram shown in FIG. 6;
FIG. 8 is a front view of the electronic device shown in FIG. 3 in some embodiments;
FIG. 9 is an S2-directional view of the electronic device shown in FIG. 8 in some embodiments; and
FIG. 10 is a schematic diagram of a hardware structure of an electronic device 100 according to some embodiments of this application.

### DESCRIPTION OF EMBODIMENTS

The following further describes in detail the technical solutions in this application with reference to the accompanying drawings.

An embodiment of this application provides an electronic device, and a flexible printed circuit in the electronic device may be grounded by using a mainboard ground member, to shorten a ground path.

It can be understood that the electronic device provided in this embodiment of this application may include but is not limited to a mobile phone, a foldable-display mobile phone, a tablet computer, a desktop computer, a laptop computer, a handheld computer, and a netbook, and electronic devices such as an augmented reality (augmented reality, AR)/virtual reality (virtual reality, VR) device, a smart television, and a smartwatch. This is not limited herein.

The following describes the electronic device by using a mobile phone 100 as an example.

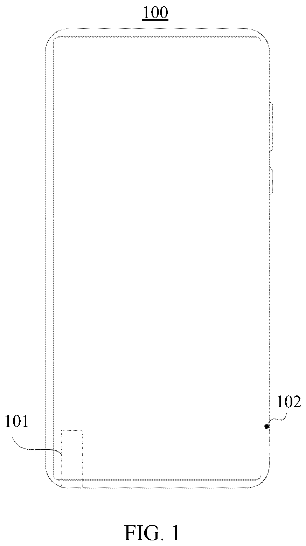

FIG. 1 is a diagram of an example structure of a mobile phone 100 according to an embodiment of this application. In the accompanying drawings of this specification, an X direction (serving as a first direction) is a thickness direction of the electronic device, and a Y direction (serving as a second direction) is a length direction of the electronic device. The X direction and the Y direction are perpendicular to each other.

Refer to FIG. 1. The mobile phone 100 may include a USB socket 101, a middle frame 102, and a mainboard 103 (not shown in the figure). The middle frame 102 is configured to bear an electronic component in the mobile phone 100, and the middle frame 102 is electrically connected to a ground wire. In this way, another component may be grounded by using the middle frame 102 after being electrically connected to the middle frame 102. It can be understood that the USB socket 101 may be electrically connected to the middle frame 102 by using screws fastened on two sides, to complete grounding.

In some embodiments, an FPC may be electrically connected to the USB socket 101 to implement grounding. However, with reference to FIG. 1, when the USB socket 101 is disposed at an edge of a body of the mobile phone 100, the USB socket cannot be fastened by using the screws. Therefore, the USB socket is of a socket type that can be welded to an HDI hard board. In this case, the USB socket cannot be grounded by using the middle frame, so that interface burning can be effectively avoided. However, the FPC cannot be directly grounded by using the USB socket.

In some grounding solutions, the FPC may be extended and electrically connected to the middle frame by using a conductive material, thereby implementing grounding processing of the FPC. The mobile phone 100 includes a middle frame, and the middle frame includes a ground wire. In this case, the FPC may be extended to an extremely long length to approach the middle frame, thereby facilitating grounding processing of the FPC. In some other grounding solutions, the FPC may be connected to the middle frame by using a preset connector and the mainboard. However, a distance between the preset connector and the socket is usually large, resulting in an excessive length of the FPC used for grounding. In both of the foregoing two grounding solutions, grounding is implemented by using an excessively long FPC. Because a magnetic field is generated around a conducting wire when a current flows through the conducting wire, this magnetic field affects generation of self inductance of the conducting wire, and also affects generation of mutual inductance of other conducting wires. If the FPC implementing grounding is excessively long, the conducting wire used for grounding is longer, and larger parasitic inductance is generated, resulting in a poor grounding effect, and low reliability of the USB socket 101. In addition, the larger parasitic inductance causes an increase in electromagnetic radiation, making it difficult to meet a design requirement related to electromagnetic radiation of a USB interface.

To implement nearby grounding of the FPC, this application provides an electronic device. The electronic device may include a flexible printed circuit, a preset connector, a mainboard, a mainboard ground member, and a conductive structural member. The mainboard is connected to the mainboard ground member, to ground by using the mainboard ground member. The conductive structural member and the preset connector are disposed between the mainboard and the flexible printed circuit, and the flexible printed circuit is electrically separately connected to the mainboard by using the conductive structural member and the preset connector, to enable the flexible printed circuit to ground by using the mainboard ground member. In this way, the flexible printed circuit (FPC) may be grounded nearby by using the conductive structural member, the mainboard 103, and the mainboard ground member 105.

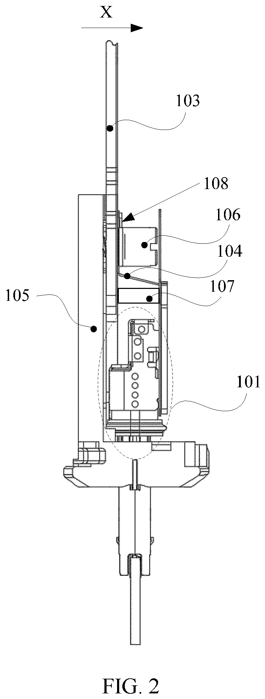

The following specifically describes, with reference to FIG. 2 to FIG. 8, the electronic device provided in this application.

FIG. 2 is a schematic diagram of a structure of an electronic device.

Refer to FIG. 2. An electronic device 100 includes a mainboard 103, an FPC 104, a mainboard ground member 105, a conductive structural member 107, and a preset connector 108. The mainboard 103 and the FPC 104 are disposed opposite to each other and spaced apart in the X direction. The electronic device 100 further includes a mainboard ground member 105, and the mainboard 103 is electrically connected to the mainboard ground member 105, to implement grounding of the mainboard 103. The FPC 104 is electrically connected to the mainboard 103 by using the conductive structural member 107, so that the FPC 104 can be grounded by using the mainboard ground member 105. The conductive structural member 107 may be a single structural member, or may include a plurality of structural members that are sequentially stacked and connected in the X direction, and is configured to electrically connect the FPC 104 to the mainboard 103, to implement nearby grounding of the FPC 104.

It can be understood that the mainboard ground member 105 may be a conductive structural member electrically connected to the ground wire connected to the middle frame 102. In some embodiments, the mainboard ground member 105 may be a preset structural member of the mobile phone 100.

In some embodiments, the electronic device 100 further includes a bolt 106 that is configured to fixedly connect the mainboard 103 to the mainboard ground member 105 in the X direction, to electrically connect the mainboard to the mainboard ground member.

It can be understood that the FPC 104 may be configured to obtain a signal or a current that is input externally to the USB interface.

Still refer to FIG. 2. The FPC 104 includes a first segment and a second segment that are connected to each other. The second segment of the FPC 104 is electrically connected to the preset connector 108 in the X direction. In some embodiments, the preset connector 108 may be a board-to-board (board to board, BTB) connector. The board-to-board connector may be configured to connect different printed circuits together, for example, connect the FPC 104 to another new FPC, thereby implementing extension of the FPC 104. In some embodiments, the FPC 104 may be electrically connected to the mainboard 103 by using the preset connector 108, to implement grounding processing. It can be understood that the conductive structural member 107 and the preset connector 108 form two locations in which the FPC 104 and the mainboard 103 are grounded. Therefore, a ground path on the FPC 104 is effectively shortened, nearby grounding of the FPC 104 is implemented, parasitic inductance of the FPC 104 is reduced, and electromagnetic radiation meets a design requirement for electromagnetic radiation of an external interface.

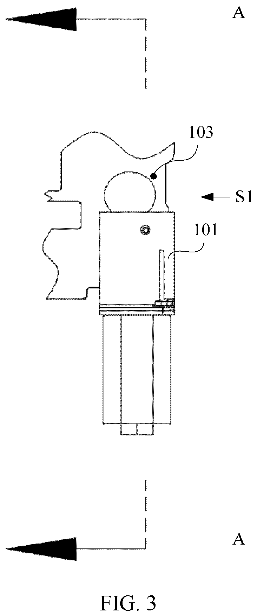

FIG. 3 is a rear view of an electronic device according to some embodiments of this application. FIG. 3 shows the mainboard 103 and the USB socket 101.

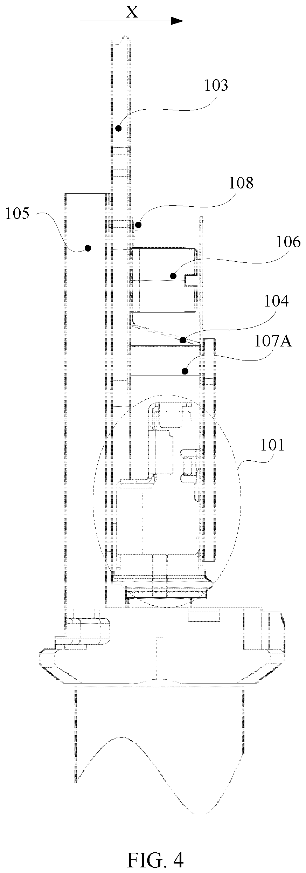

FIG. 4 is an S1-directional view of the electronic device shown in FIG. 3 in some embodiments.

As shown in FIG. 4, a first structural member 107A may be used as the conductive structural member 107 to electrically connect the FPC 104 to the mainboard 103. The mainboard 103, the first structural member 107A, and the FPC 104 are sequentially stacked and connected in the X direction.

It can be understood that the first structural member 107A is a conductive structural member that electrically connects the FPC 104 to the mainboard 103, so that the FPC 104 can be electrically connected to the mainboard ground member 105 by using the mainboard 103. Because the mainboard ground member 105 is electrically connected to the ground wire connected to the middle frame of the mobile phone, the ground path is shortened compared with a ground location of the preset connector 108, thereby implementing nearby grounding of the FPC 104. In this way, the parasitic inductance of the FPC can be reduced, thereby facilitating improvement of reliability of the USB socket 101.

In some embodiments, the first structural member 107A may be a flexible member or a rigid member. The flexible member may be conductive foam, and the rigid member may be a conductive elastic piece. For example, the first structural member 107A may be a conductive elastic piece, is fastened to the mainboard 103, and is elastically connected to the FPC 104 in the X direction, to electrically connect the FPC 104 to the mainboard 103, thereby effectively ensuring grounding reliability. This may further help mount the USB socket 101 on the mainboard in a down-pressing manner, so that the foregoing mounting manner can be applied to a plurality of relative spacing distances between the FPC and the mainboard, and can be used in a plurality of mounting environments, with higher mounting adaptability, thereby reducing mounting inconvenience.

It can be understood that the conductive elastic piece or the conductive foam may fill a relative spacing distance between the FPC 104 and the mainboard 103 in the X direction, to ensure grounding reliability of the FPC 104.

In some embodiments, the conductive elastic piece may be formed by a multi-layer conductive sheet-like rigid material, and has elasticity.

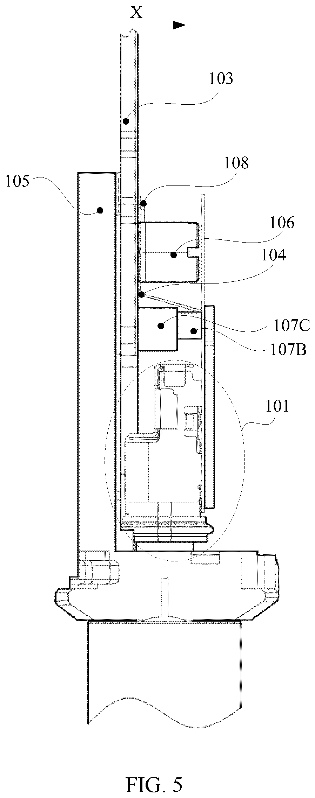

FIG. 5 is an S1-directional view of the electronic device shown in FIG. 3 in some other embodiments.

As shown in FIG. 5, a second structural member 107B and a third structural member 107C may be combined into the conductive structural member 107, to electrically connect the FPC 104 to the mainboard 103. The mainboard 103, the third structural member 107C, the second structural member 107B, and the FPC 104 are sequentially stacked and connected in the X direction, and the third structural member 107C is located on one side that is of the second structural member 107B and that faces away from the FPC 104.

Still refer to FIG. 5. Compared with the first structural member 107A in FIG. 4, a thickness of the second structural member 107B in the X direction may be reduced by the second structural member 107B and the third structural member 107C that are stacked in the X direction, thereby ensuring structural strength of the second structural member 107B.

In some embodiments, the second structural member 107B may be a rigid member with elasticity, for example, may be a conductive elastic piece. The third structural member 107C may be a rigid member or a flexible member. On the one hand, the second structural member 107B may be thickened in the X direction after the third structural member 107C is added, so that a standard member, for example, a standard elastic piece, is used as the second structural member 107B, thereby effectively reducing production costs. On the other hand, an excessively thick design of the elastic piece in the X direction may be avoided by using the third structural member 107C, thereby avoiding low elasticity of the elastic piece, and ensuring elasticity of the elastic piece to ensure grounding reliability of the FPC 104 and the mainboard.

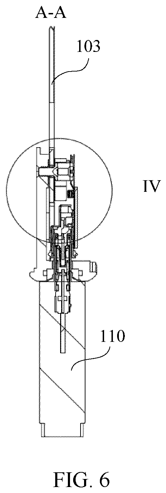

FIG. 6 is an A-A cross-sectional diagram of the electronic device shown in FIG. 3.

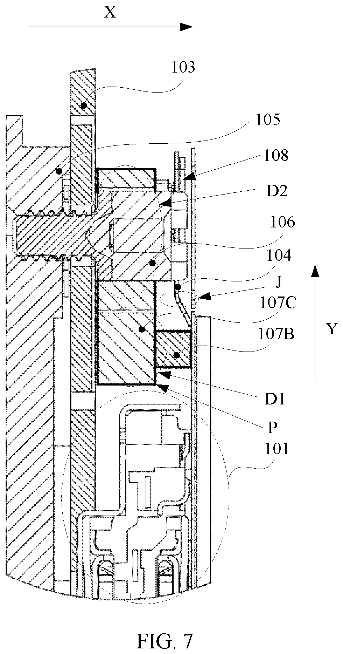

As shown in FIG. 6, the mainboard 103 is connected to the USB socket 101 (not shown in the figure), and a USB interface housing is marked as 110. To better show a schematic cross-sectional diagram of the electronic device shown in FIG. 6, the following describes a region IV in FIG. 6 through enlarge in FIG. 7.

FIG. 7 is a partially enlarged view of a region IV in the A-A cross-sectional diagram shown in FIG. 6, and an enlarge scale of the local part may be, for example, 5:1.

As shown in FIG. 7, a relative spacing distance between the FPC 104 and the mainboard 103 is filled with the second structural member 107B and the third structural member 107C, to electrically connect the FPC 104 to the mainboard 103.

Still refer to FIG. 7. The mainboard ground member 105 is fixedly connected to the mainboard 103 in the X direction by using the bolt 106, to electrically connect the mainboard ground member 105 to the mainboard 103. Therefore, a ground path shown in FIG. 7 is formed: the FPC 104→the second structural member 107B→the third structural member 107C→the mainboard 103→the bolt 106→the mainboard ground member 105→the middle frame. Compared with a ground path "the FPC 104→the preset connector 108→the mainboard 103→the bolt 106→the mainboard ground member 105→the middle frame", the ground path shown in FIG. 7 is shorter, so that nearby grounding of the FPC 104 is effectively implemented, and the parasitic inductance generated by the FPC is reduced, thereby improving grounding reliability.

Further, still refer to FIG. 7. The FPC 104 includes a first segment and a second segment in the Y direction, where the board-to-board connector 108 is disposed on the second segment. The third structural member 107C includes, in the Y direction, a first part D1 and a second part D2 that are connected to each other. The second part D2 of the third structural member 107C supports the second segment of the FPC 104 in the X direction, and the first part D1 of the third structural member 107C supports the second structural member 107B in the X direction, to further support the first segment that is of the FPC 104 and on which the board-to-board connector 108 is disposed. After the third structural member 107C is added, compared with the FPC 104 in FIG. 4 or FIG. 5, a bending angle of the FPC 104 in FIG. 7 at a location J is enlarged, thereby effectively prolonging a service life of the FPC.

In some embodiments, the third structural member 107C may be electrically connected to the bolt 106.

In some embodiments, the second structural member 107B may be a conductive elastic piece or the like, and a thickness of the third structural member 107C in the X direction may be determined based on the relative spacing distance between the FPC 104 and the mainboard 103 in the X direction and the thickness of the second structural member 107B in the X direction.

It can be understood that both the second structural member 107B and the third structural member 107C may be electrically conductive.

In an example, the third structural member 107C may be, for example, conductive foam or conductive fabric.

In some embodiments, still refer to FIG. 7. The USB socket 101 is located on one side of the conductive structural member in the Y direction. The second structural member 107B may be disposed in a region within a boundary P of the third structural member 107C, so that a distance between the third structural member 107C and the USB socket 101 is less than a distance between the second structural member 107B and the USB socket 101 in the Y direction. Further, the USB socket 101 first contacts the third structural member 107C in a process of mounting the USB socket 101. Therefore, the second structural member 107B is effectively prevented from being scratched when the USB socket 101 is mounted, to avoid damaging the second structural member 107B, thereby increasing an assembly yield of the electronic device 100 on a production line, and ensuring grounding reliability of the FPC.

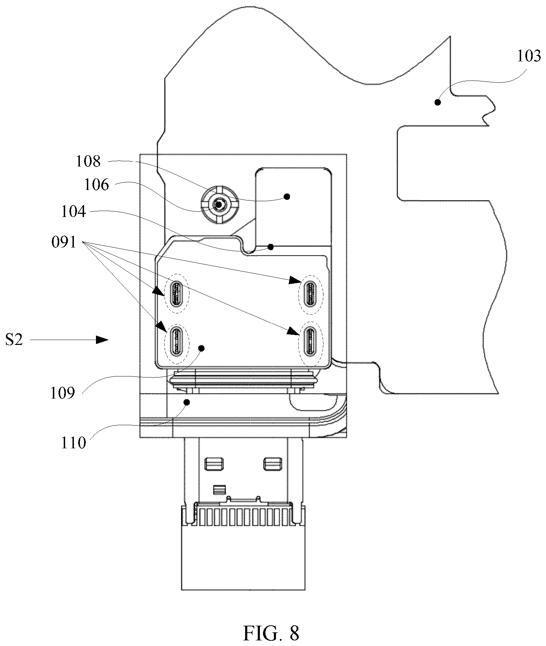

FIG. 8 is a front view of the electronic device shown in FIG. 3 in still some embodiments.

As shown in FIG. 8, the electronic device further includes a reinforcement plate 109. Refer to FIG. 8. Because there is no enough space on a left side of the mainboard 103 to dispose a screw, the USB socket 101 may be welded to the reinforcement plate 109 to fasten the USB socket 101 (not shown in the figure). As shown in the figure, fastening reliability of the USB socket 101 can be ensured by welding pins of the USB socket 101 into four preset holes 091 on the reinforcement plate 109.

It can be understood that the reinforcement plate 109 may be made of a conductive material.

It can be understood that a process for welding the reinforcement plate 109 to the USB socket 101 through the preset holes 091 may be dual inline-pin package (dual inline-pin package, DIP), to ensure welding stability by using a through hole insertion welding process.

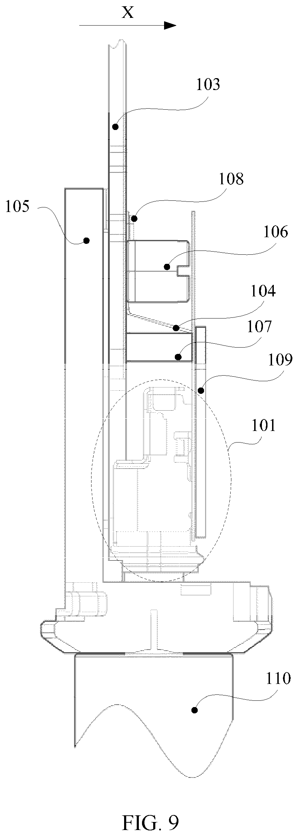

FIG. 9 is an S2-directional view of the electronic device shown in FIG. 8.

Refer to FIG. 9. The mainboard 103, the USB socket 101, the FPC 104, and the reinforcement plate 109 may be sequentially stacked and connected in the X direction. The FPC 104 may be clamped between the USB socket 101 and the reinforcement plate 109 in the X direction. On the one hand, the reinforcement plate 109 may be configured to perform stress reinforcement for the FPC 104, so that the FPC 104 can be better fastened by the USB socket 101, and the relative spacing distance between the FPC 104 and the mainboard 103 is kept stable. On the other hand, the reinforcement plate 109 and the USB socket 101 are not connected to the USB interface housing 110, to avoid a short circuit caused by a circuit formed by the USB interface housing 110 and the USB socket 101, thereby ensuring reliability of the USB socket 101.

In some embodiments, a projection of the reinforcement plate 109 may be at least partially overlapped with a projection of the conductive structural member 107, thereby performing reinforcement processing for the FPC 104. The USB socket 101 and the reinforcement plate 109 may be fastened through welding. Therefore, a location relationship between the FPC 104 and the reinforcement plate 109 is fixed. Therefore, grounding stability of the FPC 104 and the mainboard 103 is ensured.

In still some embodiments, when the conductive structural member 107 is the first structural member 107A, the projection of the reinforcement plate 109 may at least partially cover a projection of the first structural member 107A in the X direction, so that the first structural member 107A can effectively support the FPC 104 in the X direction.

In some other embodiments, when the conductive structural member 107 includes the second structural member 107B and the third structural member 107C that are stacked and connected in the X direction, the projection of the reinforcement plate 109 may at least partially cover a projection of the second structural member 107B, so that the second structural member 107B and the third structural member 107C can effectively support the FPC 104 in the X direction.

It can be understood that the USB socket 101 includes but is not limited to a USB Type-C socket.

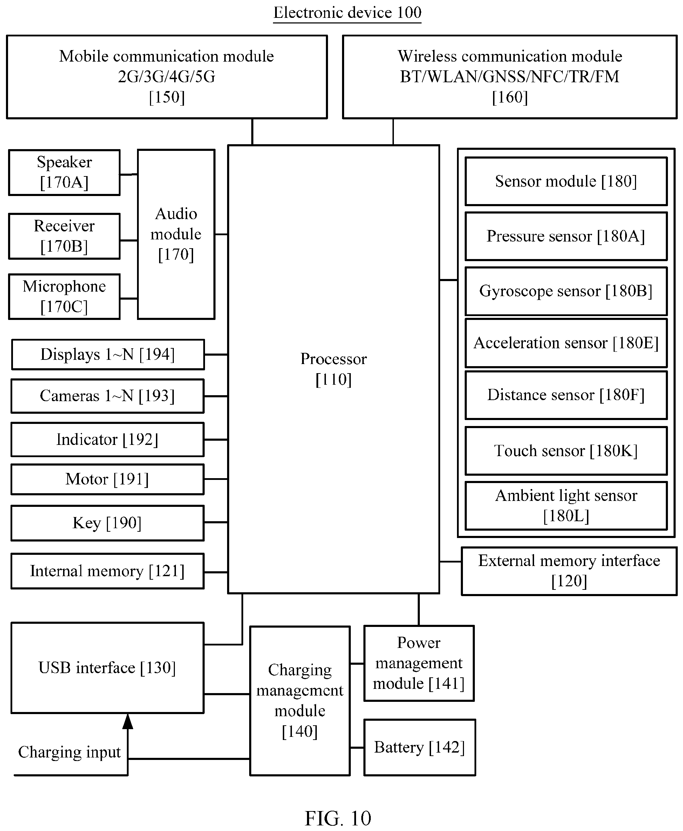

FIG. 10 is a schematic diagram of a hardware structure of an electronic device 100 according to some embodiments of this application.

As shown in FIG. 10, the electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a key 190, a motor 191, an indicator 192, a camera 193, a display 194, a subscriber identification module (subscriber identification module, SIM) card interface 195, and the like. The sensor module 180 may include a pressure sensor 180A, a gyroscope sensor 180B, an acceleration sensor 180E, a distance sensor 180F, a touch sensor 180K, an ambient light sensor 180L, and the like.

It can be understood that the structure illustrated in this embodiment of this application constitutes no specific limitation on the electronic device 100. In some other embodiments of this application, the electronic device 100 may include more or fewer components than those shown in the figure, combine some components, split some components, or have different component arrangements. This is not limited herein.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, and the like. Different processing units may be independent devices, or may be integrated into one or more processors.

A memory may be further disposed in the processor 110 to store instructions and data.

In some embodiments, the processor 110 may include one or more interfaces. In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI) interface, a general-purpose input/output (general-purpose input/output, GPIO) interface, a subscriber identity module (subscriber identity module, SIM) interface, a universal serial bus (universal serial bus, USB) interface, and/or the like. The USB interface 130 may be configured to connect to a charger to charge the electronic device 100, or may be configured to transmit data between the electronic device 100 and a peripheral device.

In some embodiments, the USB interface 130 includes a USB Type-C interface.

The I2C interface is a bidirectional synchronous serial bus, including a serial data line (serial data line, SDA) and a serial clock line (serial clock line, SCL). In some embodiments, the processor 110 may include a plurality of groups of I2C buses. The processor 110 may be separately coupled to the touch sensor 180K, the charger, a flash, the camera 193, and the like through different I2C bus interfaces. For example, the processor 110 may be coupled to the touch sensor 180K through the I2C interface, so that the processor 110 communicates with the touch sensor 180K through the I2C bus interface, to implement a touch function of the electronic device 100.

The charging management module 140 is configured to receive a charging input from the charger. The power management module 141 is configured to connect to the battery 142, the charging management module 140, and the processor 110. The power management module 141 receives an input from the battery 142 and/or the charging management module 140, and supplies power to the processor 110, the internal memory 121, the display 194, the camera 193, the wireless communication module 160, and the like.

A wireless communication function of the electronic device 100 may be implemented by using the antenna 1, the antenna 2, the mobile communication module 150, the wireless communication module 160, the modem processor, a baseband processor, and the like.

The antenna 1 and the antenna 2 are configured to transmit and receive electromagnetic wave signals. Each antenna in the electronic device 100 may be configured to cover one or more communication frequency bands. Different antennas may be further multiplexed to improve antenna utilization.

The electronic device 100 implements a display function by using the GPU, the display 194, the application processor, and the like. The GPU is a microprocessor for image processing and is connected to the display 194 and the application processor. The GPU is configured to perform mathematical and geometric calculation for graphics rendering. The processor 110 may include one or more GPUs that execute program instructions to generate or change displayed information.

The display 194 is configured to display an image, a video, and the like. The display 194 includes a display panel. In some embodiments, the electronic device 100 may include one or N displays 194, where N is a positive integer greater than 1.

The electronic device 100 may implement a shooting function by using the ISP, the camera 193, the video codec, the GPU, the display 194, the application processor, and the like.

The ISP is configured to process data fed back by the camera 193.

The camera 193 is configured to capture a still image or a video. An optical image of an object is generated through a lens and is projected onto a photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transfers the electrical signal to the ISP to convert the electrical signal into a digital image signal. The ISP outputs the digital image signal to the DSP for processing. The DSP converts the digital image signal into an image signal in a standard format, for example, RGB or YUV. In some embodiments, the electronic device 100 may include one or N cameras 193, where N is a positive integer greater than 1.

The external memory interface 120 may be configured to connect to an external memory card, for example, a Micro SD card, to expand a storage capability of the electronic device 100.

The internal memory 121 may be configured to store computer-executable program code, and the executable program code includes instructions. The internal memory 121 may include a program storage area and a data storage area.

The electronic device 100 may implement an audio function by using the audio module 170, the speaker 170A, the receiver 170B, the microphone 170C, the headset jack 170D, the application processor, and the like. For example, music playing and sound recording are implemented.

The pressure sensor 180A is configured to sense a pressure signal, and may convert the pressure signal into an electrical signal. In some embodiments, the pressure sensor 180A may be disposed on the display 194.

There are many types of pressure sensors 180A, such as a resistive pressure sensor, an inductive pressure sensor, and a capacitive pressure sensor. The capacitive pressure sensor may include at least two parallel plates having a conductive material. When force is applied to the pressure sensor 180A, capacitance between electrodes changes. The electronic device 100 determines intensity of a pressure based on a change of the capacitance. When a touch operation acts on the display 194, the electronic device 100 detects strength of the touch operation by using the pressure sensor 180A. The electronic device 100 may also calculate a touch location based on a detected signal of the pressure sensor 180A.

The gyroscope sensor 180B may be configured to determine a motion posture of the electronic device 100.

The acceleration sensor 180E may detect magnitudes of acceleration in various directions (usually on three axes) of the electronic device 100, and may detect a magnitude and a direction of gravity when the electronic device 100 is still. The acceleration sensor 180E may be further configured to identify a posture of the electronic device, and is applied to applications such as switching between a landscape mode and a portrait mode.

The distance sensor 180F is configured to measure a distance. The electronic device 100 may measure the distance in an infrared or a laser manner.

The ambient light sensor 180L is configured to sense ambient light brightness.

The touch sensor 180K is also referred to as a "touch panel". The touch sensor 180K may be disposed on the display 194. The touch sensor 180K and the display 194 form a touchscreen, also referred to as a "touch control screen".

It should be noted that in the examples and specification of this patent, relational terms such as first and second are only used to distinguish one entity or operation from another entity or operation, and do not necessarily require or imply that there is any such actual relationship or order between these entities or operations. In addition, the term "include", "comprise", or any other variant thereof is intended to cover non-exclusive inclusion, so that a process, method, article, or device that includes a series of elements includes not only those elements but also other elements that are not expressly listed, or includes elements inherent to such a process, method, article, or device. Without further limitation, the element defined by the sentence "including a" does not exclude that other identical elements also exist in the process, method, article, or device including the element.

## Claims

1. An electronic device (100), wherein the electronic device (100) comprises a flexible printed circuit (104), a preset connector (108), a mainboard (103), a mainboard ground member (105), and a conductive structural member (107);
the mainboard (103) and the flexible printed circuit (104) are disposed opposite to each other and spaced apart in a first direction, and the mainboard (103) is connected to the mainboard ground member (105), to ground by using the mainboard ground member (105); and
the conductive structural member (107) and the preset connector (108) are disposed between the mainboard (103) and the flexible printed circuit (104), and the flexible printed circuit (104) is electrically connected to the mainboard (103) by using the conductive structural member (107) and the preset connector (108), to enable the flexible printed circuit (104) to ground by using the mainboard ground member (105), wherein the electronic device (100) comprises a reinforcement plate (109), an external interface, and an interface socket configured to mount the external interface; and
the flexible printed circuit (104) is clamped between the interface socket and the reinforcement plate (109) in the first direction.

2. The electronic device (100) according to claim 1, wherein a projection of the conductive structural member (107) on the flexible printed circuit (104) is at least partially overlapped with a projection of the reinforcement plate (109) on the flexible printed circuit (104).

3. The electronic device (100) according to claim 1, wherein the conductive structural member (107) is a first structural member (107A), wherein the first structural member (107A) comprises a rigid material.

4. The electronic device (100) according to claim 1, wherein the conductive structural member (107) comprises a second structural member (107B) and a third structural member (107C) that are stacked in the first direction, and the third structural member (107C) is located on one side that is of the second structural member (107B) and that faces away from the flexible printed circuit (104).

5. The electronic device (100) according to claim 4, wherein the second structural member (107B) comprises a rigid material, and the third structural member (107C) comprises a flexible material or a rigid material.

6. The electronic device (100) according to claim 5, wherein the flexible material is conductive foam, and the rigid material is a conductive elastic piece.

7. The electronic device (100) according to any one of claims 4 to 6, wherein the flexible printed circuit (104) comprises, in a second direction, a first segment and a second segment that are connected to each other, and the second direction is perpendicular to the first direction.

8. The electronic device (100) according to claim 7, wherein the third structural member (107C) comprises, in the second direction, a first part and a second part that are connected to each other, the third structural member (107C) is overlapped with the first segment of the flexible printed circuit (104) by using the first part.

9. The electronic device (100) according to claim 8, wherein the second part of the third structural member (107C) is configured to provide the second segment of the flexible printed circuit (104) with support in the first direction.

10. The electronic device (100) according to claim 9, wherein the interface socket is located between the mainboard (103) and the flexible printed circuit (104) in the first direction, and the interface socket is located on a first side of the conductive structural member (107) in the second direction; and
a distance between the third structural member (107C) and the interface socket is less than a distance between the second structural member (107B) and the interface socket in the second direction.

11. The electronic device (100) according to any one of claims 4 to 6, wherein parts of the third structural member (107C) have a same thickness, and the thickness is a size of the third structural member (107C) in the first direction.

12. The electronic device (100) according to any one of claims 1 to 10, wherein the external interface comprises a USB interface (130) or a SIM card interface.

## Patentansprüche

1. Elektronische Vorrichtung (100), wobei die elektronische Vorrichtung (100) eine flexible gedruckte Schaltung (104), einen voreingestellten Steckverbinder (108), eine Hauptplatine (103), ein Hauptplatinen-Masseelement (105) und ein leitfähiges Strukturelement (107) umfasst;
die Hauptplatine (103) und die flexible gedruckte Schaltung (104) einander gegenüberliegend und in einer ersten Richtung voneinander beabstandet angeordnet sind, und die Hauptplatine (103) mit dem Hauptplatinen-Masseelement (105) verbunden ist, um unter Verwendung des Hauptplatinen-Masseelements (105) geerdet zu werden; und
das leitfähige Strukturelement (107) und der voreingestellte Steckverbinder (108) zwischen der Hauptplatine (103) und der flexiblen gedruckten Schaltung (104) angeordnet sind, und die flexible gedruckte Schaltung (104) elektrisch mit der Hauptplatine (103) unter Verwendung des leitfähigen Strukturelements (107) und des voreingestellten Steckverbinders (108) verbunden ist, um zu ermöglichen, dass die flexible gedruckte Schaltung (104) unter Verwendung des Hauptplatinen-Masseelements (105) geerdet wird, wobei die elektronische Vorrichtung (100) eine Verstärkungsplatte (109), eine externe Schnittstelle und eine Schnittstellenbuchse umfasst, die dazu konfiguriert ist, die externe Schnittstelle zu montieren; und
die flexible gedruckte Schaltung (104) zwischen der Schnittstellenbuchse und der Verstärkungsplatte (109) in der ersten Richtung eingeklemmt ist.

2. Elektronische Vorrichtung (100) nach Anspruch 1, wobei eine Projektion des leitfähigen Strukturelements (107) auf die flexible gedruckte Schaltung (104) zumindest teilweise mit einer Projektion der Verstärkungsplatte (109) auf die flexible gedruckte Schaltung (104) überlappt.

3. Elektronische Vorrichtung (100) nach Anspruch 1, wobei das leitfähige Strukturelement (107) ein erstes Strukturelement (107A) ist, wobei das erste Strukturelement (107A) ein starres Material umfasst.

4. Elektronische Vorrichtung (100) nach Anspruch 1, wobei das leitfähige Strukturelement (107) ein zweites Strukturelement (107B) und ein drittes Strukturelement (107C) umfasst, die in der ersten Richtung gestapelt sind, und das dritte Strukturelement (107C) sich auf einer Seite des zweiten Strukturelements (107B) befindet, die von der flexiblen gedruckten Schaltung (104) abgewandt ist.

5. Elektronische Vorrichtung (100) nach Anspruch 4, wobei das zweite Strukturelement (107B) ein starres Material umfasst und das dritte Strukturelement (107C) ein flexibles Material oder ein starres Material umfasst.

6. Elektronische Vorrichtung (100) nach Anspruch 5, wobei das flexible Material leitfähiger Schaumstoff ist und das starre Material ein leitfähiges elastisches Element ist.

7. Elektronische Vorrichtung (100) nach einem der Ansprüche 4 bis 6, wobei die flexible gedruckte Schaltung (104) in einer zweiten Richtung ein erstes Segment und ein zweites Segment umfasst, die miteinander verbunden sind, und die zweite Richtung senkrecht zur ersten Richtung ist.

8. Elektronische Vorrichtung (100) nach Anspruch 7, wobei das dritte Strukturelement (107C) in der zweiten Richtung einen ersten Teil und einen zweiten Teil umfasst, die miteinander verbunden sind, wobei das dritte Strukturelement (107C) mit dem ersten Segment der flexiblen gedruckten Schaltung (104) unter Verwendung des ersten Teils überlappt.

9. Elektronische Vorrichtung (100) nach Anspruch 8, wobei der zweite Teil des dritten Strukturelements (107C) dazu konfiguriert ist, das zweite Segment der flexiblen gedruckten Schaltung (104) mit Unterstützung in der ersten Richtung zu versehen.

10. Elektronische Vorrichtung (100) nach Anspruch 9, wobei die Schnittstellenbuchse zwischen der Hauptplatine (103) und der flexiblen gedruckten Schaltung (104) in der ersten Richtung angeordnet ist, und die Schnittstellenbuchse auf einer ersten Seite des leitfähigen Strukturelements (107) in der zweiten Richtung angeordnet ist; und
ein Abstand zwischen dem dritten Strukturelement (107C) und der Schnittstellenbuchse geringer als ein Abstand zwischen dem zweiten Strukturelement (107B) und der Schnittstellenbuchse in der zweiten Richtung ist.

11. Elektronische Vorrichtung (100) nach einem der Ansprüche 4 bis 6, wobei Teile des dritten Strukturelements (107C) eine gleiche Dicke aufweisen, und die Dicke eine Größe des dritten Strukturelements (107C) in der ersten Richtung ist.

12. Elektronische Vorrichtung (100) nach einem der Ansprüche 1 bis 10, wobei die externe Schnittstelle eine USB-Schnittstelle (130) oder eine SIM-Karten-Schnittstelle umfasst.

## Revendications

1. Dispositif électronique (100), dans lequel le dispositif électronique (100) comprend un circuit imprimé flexible (104), un connecteur prédéfini (108), une carte mère (103), un élément de mise à la terre de carte mère (105), et un élément structurel conducteur (107) ;
la carte mère (103) et le circuit imprimé flexible (104) sont disposés à l'opposé l'un de l'autre et espacés dans une première direction, et la carte mère (103) est connectée à l'élément de mise à la terre de carte mère (105), pour être mise à la terre en utilisant l'élément de mise à la terre de carte mère (105) ; et
l'élément structurel conducteur (107) et le connecteur prédéfini (108) sont disposés entre la carte mère (103) et le circuit imprimé flexible (104), et le circuit imprimé flexible (104) est connecté électriquement à la carte mère (103) en utilisant l'élément structurel conducteur (107) et le connecteur prédéfini (108), pour permettre au circuit imprimé flexible (104) d'être mis à la terre en utilisant l'élément de mise à la terre de carte mère (105), dans lequel le dispositif électronique (100) comprend une plaque de renforcement (109), une interface externe, et une prise d'interface configurée pour monter l'interface externe ; et
le circuit imprimé flexible (104) est enserré entre la prise d'interface et la plaque de renforcement (109) dans la première direction.

2. Dispositif électronique (100) selon la revendication 1, dans lequel une projection de l'élément structurel conducteur (107) sur le circuit imprimé flexible (104) est au moins partiellement chevauchée par une projection de la plaque de renforcement (109) sur le circuit imprimé flexible (104).

3. Dispositif électronique (100) selon la revendication 1, dans lequel l'élément structurel conducteur (107) est un premier élément structurel (107A), dans lequel le premier élément structurel (107A) comprend un matériau rigide.

4. Dispositif électronique (100) selon la revendication 1, dans lequel l'élément structurel conducteur (107) comprend un deuxième élément structurel (107B) et un troisième élément structurel (107C) qui sont empilés dans la première direction, et le troisième élément structurel (107C) est situé sur un côté du deuxième élément structurel (107B) qui est orienté à l'opposé du circuit imprimé flexible (104).

5. Dispositif électronique (100) selon la revendication 4, dans lequel le deuxième élément structurel (107B) comprend un matériau rigide, et le troisième élément structurel (107C) comprend un matériau flexible ou un matériau rigide.

6. Dispositif électronique (100) selon la revendication 5, dans lequel le matériau flexible est une mousse conductrice, et le matériau rigide est une pièce élastique conductrice.

7. Dispositif électronique (100) selon l'une quelconque des revendications 4 à 6, dans lequel le circuit imprimé flexible (104) comprend, dans une seconde direction, un premier segment et un second segment qui sont connectés l'un à l'autre, et la seconde direction est perpendiculaire à la première direction.

8. Dispositif électronique (100) selon la revendication 7, dans lequel le troisième élément structurel (107C) comprend, dans la seconde direction, une première partie et une seconde partie qui sont connectées l'une à l'autre, le troisième élément structurel (107C) est en chevauchement avec le premier segment du circuit imprimé flexible (104) en utilisant la première partie.

9. Dispositif électronique (100) selon la revendication 8, dans lequel la seconde partie du troisième élément structurel (107C) est configurée pour fournir au second segment du circuit imprimé flexible (104) un support dans la première direction.

10. Dispositif électronique (100) selon la revendication 9, dans lequel la prise d'interface est située entre la carte mère (103) et le circuit imprimé flexible (104) dans la première direction, et la prise d'interface est située sur un premier côté de l'élément structurel conducteur (107) dans la seconde direction ; et une distance entre le troisième élément structurel (107C) et la prise d'interface est inférieure à une distance entre le deuxième élément structurel (107B) et la prise d'interface dans la seconde direction.

11. Dispositif électronique (100) selon l'une quelconque des revendications 4 à 6, dans lequel des parties du troisième élément structurel (107C) ont une même épaisseur, et l'épaisseur est une dimension du troisième élément structurel (107C) dans la première direction.

12. Dispositif électronique (100) selon l'une quelconque des revendications 1 à 10, dans lequel l'interface externe comprend une interface USB (130) ou une interface de carte SIM.
